# FASCICULE DE BREVET EUROPEEN

(11) **EP 0 762 639 B1**
(45) Date de publication et mention de la délivrance du brevet: **09.04.2003**
(21) Numéro de dépôt: 96401769.3
(22) Date de dépôt: 12.08.1996
(51) Int. Cl.: H03G 3/34, H04L 1/20

(54) **Dispositif de commande de volume sonore pour récepteur de signaux de parole codés par blocs**
Vorrichtung zum Einstellen der Lautstärke in einem Empfänger für blockkodierte Sprachsignale
Sound volume control signal for a receiver for block coded speech signals

(30) Priorité: 16.08.1995 FR 9509839
(43) Date de publication de la demande: 12.03.1997
(73) Titulaire: ALCATEL, 75008 Paris (FR)
(72) Inventeur: Palumbo, Nicolas, 75012 Paris (FR)
(74) Mandataire: El Manouni, Josiane

(56) Documents cités:
- WO-A-94/29849
- US-A- 5 349 701
- US-A- 5 414 711
- US-A- 5 416 779
- COMMUNICATIONS TECHNOLOGY FOR THE 1990'S AND BEYOND, DALLAS, NOV. 27 - 30, 1989, vol. 2 OF 3, 27 Novembre 1989, INSTITUTE OF ELECTRICAL AND ELECTRONICS ENGINEERS, pages 1070-1074, XP000091191 SOUTHCOTT C B ET AL: "VOICE CONTROL OF THE PAN-EUROPEAN DIGITAL MOBILE RADIO SYSTEM"

## Description

La présente invention concerne d'une manière générale les systèmes de transmission numérique de signaux de parole, notamment les systèmes de radiotéléphonie, dans lesquels est mis en oeuvre, en émission, un codage réducteur de débit et, en réception, un décodage correspondant.

La présente invention concerne plus particulièrement de tels systèmes dans lesquels ledit codage réducteur de débit est un codage dit par blocs réalisé, de manière connue, en extrayant, sur des intervalles de temps de durée déterminée (typiquement 20 ms) pendant lesquels on peut considérer que les caractéristiques des signaux de parole sont stables, des paramètres représentatifs de ces signaux de parole, et en transmettant ces paramètres, plutôt que les signaux eux-mêmes, dans des entités appelées blocs, ou aussi trames de phonie.

La présente invention concerne plus particulièrement encore de tels systèmes dans lesquels on effectue, en réception, une estimation quant à la nature acceptable ou non acceptable des blocs reçus, un bloc reçu pouvant notamment être estimé non acceptable parce que sa qualité de transmission (déterminée suivant des méthodes connues, en réception) est insuffisante.

Il est connu, et rappelé notamment par le document WO 94/29849, de remplacer des blocs estimés non acceptables par des blocs obtenus en réalisant une interpolation de ces blocs avec des blocs précédents estimés acceptables, et en réduisant parallèlement le volume sonore, jusqu'à couper complètement ce volume sonore au bout d'un certain temps si les blocs continuent d'être non acceptables.

La présente invention a notamment pour but de fournir un dispositif de commande de volume sonore pour un récepteur de signaux de parole codés par blocs apte à recevoir des signaux transmis suivant la technique dite de transmission discontinue (ou " DTX" : " Discontinuous Transmission ").

La présente invention a en particulier pour but de fournir un dispositif de commande de volume sonore pour un récepteur de signaux de parole codés par blocs, qui puisse fonctionner aussi bien dans le cas où est mise en oeuvre, à destination de ce récepteur, une telle technique de transmission discontinue que dans le cas où n'est pas mise en oeuvre une telle technique.

On rappelle brièvement que la technique dite de transmission discontinue, destinée notamment à réduire le niveau d'interférence dans un système cellulaire tel que le système GSM par exemple, consiste à ne transmettre aucune information (ce qui est assimilé dans ce qui suit à la transmission de blocs "vides") en l'absence d'activité vocale, si ce n'est un bruit dit "de confort", destiné à éviter de faire croire, en réception, à une coupure de communication, mais dont le débit est très inférieur à celui des informations de parole.

Ainsi, dans un système de radiocommunications mobiles tel que le système GSM par exemple, les blocs correspondant au bruit de confort sont transmis dans des trames déterminées, dites trames "SID" ("SIlence Description frames") d'une structure de multitrame, les autres trames de cette multitrame étant des blocs "vides" (les termes trame et multitrame se référant ici à une structure de multiplex temporel utilisée pour la transmission dans un tel système).

Pour de plus amples détails sur cette technique de transmission discontinue, on pourra se référer par exemple au livre de Michel MOULY et Marie-Bernadette PAUTET, intitulé:"The GSM System for Mobile Communications" (ISBN: 2-9507190-0-7).

Les blocs "vides" correspondant aux trames autres que les trames SID étant considérés comme des blocs non acceptables, sont remplacés, par extrapolation, par le bruit de confort transporté dans des trames SID précédentes. Un problème se pose cependant avec un récepteur du type rappelé plus haut, c'est-à-dire dans lequel on effectue une réduction, voire une coupure, de volume sonore en cas de blocs non acceptables, qui est que le confort d'écoute n'est pas optimal puisque la restitution du bruit de confort n'est pas alors optimale.

La présente invention permet notamment d'éviter cet inconvénient.

La présente invention a ainsi pour objet un dispositif de commande de volume sonore pour récepteur de signaux de parole codés par blocs, ce récepteur étant apte à recevoir des signaux transmis suivant une transmission discontinue et comportant des moyens pour réaliser une estimation quant à la nature acceptable ou non acceptable des blocs reçus, ce dispositif comportant des moyens pour commander une réduction de volume sonore dans le cas de réception de blocs non acceptables, et ce dispositif étant essentiellement caractérisé en ce qu'il comporte :
- des moyens dits de détection pour évaluer, grâce aux résultats de ladite estimation, une séquence de blocs consécutifs non acceptables et acceptables correspondent à une configuration utilisée en transmission discontinue, afin de determiner si les signaux reçus sont des signaux transmis suivant ladite transmission discontinue,
- des moyens pour commander un rétablissement de volume sonore dans le cas d'une détection, de transmission discontinue des signaux.

D'autres objets et caractéristiques de la présente invention apparaîtront à la lecture de la description suivante d'un exemple de réalisation, faite en relation avec les dessins ci-annexés dans lesquels :
- la figure 1 représente schématiquement les différents éléments d'un récepteur de signaux de parole codés par blocs, avec lesquels coopère un dispositif de commande de volume sonore suivant l'invention;
- la figure 2 est un schéma général d'un exemple de réalisation d'un dispositif de commande de volume sonore suivant l'invention;
- la figure 3 illustre un exemple d'algorithme de fonctionnement d'un dispositif de commande de volume sonore tel qu'illustré sur la figure 2.

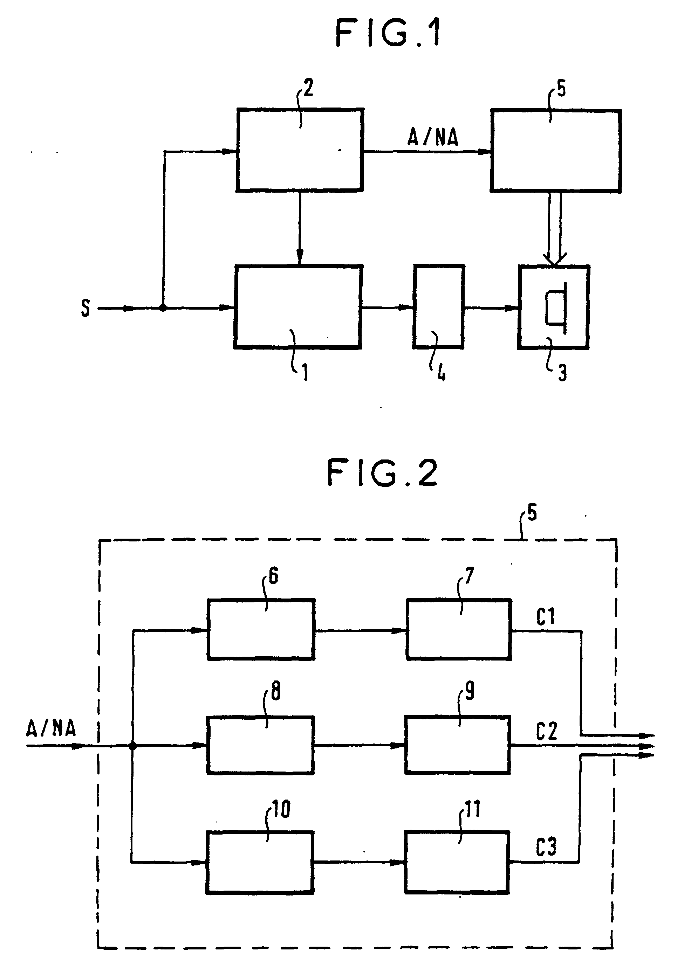

Sur la figure 1 sont illustrés :
- un décodeur, 1, recevant des blocs de parole codés par blocs, notés S,
- des moyens, 2, recevant les mêmes blocs de parole codés, S, réalisant une estimation quant à la nature acceptable ou non acceptable de ces blocs de parole, et commandant la mise en place, dans le décodeur 1, d'un processus d'interpolation, ou d'extrapolation, de blocs en cas d'estimation de blocs non acceptables,
- un haut-parleur, 3, recevant les signaux issus du décodeur 1, après passage dans un convertisseur numérique-analogique 4,
- un dispositif 5 de commande de volume sonore à appliquer au haut-parleur 3, ce dispositif de commande de volume sonore recevant également, des moyens 2, des informations quant à la nature acceptable ou non des blocs reçus, ces informations étant notées A/NA.

Un dispositif de commande de volume sonore suivant l'invention comporte, comme illustré sur la figure 2 :
- des moyens, 10, pour détecter si les signaux reçus sont des signaux transmis suivant une transmission discontinue,
- des moyens, 11, pour commander un rétablissement de volume sonore dans le cas d'une telle détection, cette commande de rétablissement étant notée C3.

Dans l'exemple considéré le dispositif de commande 5 comporte en outre:
- des moyens, 8, pour détecter une séquence de blocs consécutifs non acceptables, ou une séquence de blocs consécutifs acceptables et non acceptables dans laquelle prédominent des blocs non acceptables, ces moyens 8 activant, dans le cas de détection d'une telle séquence,
- des moyens, 9, pour commander une réduction de volume sonore, cette commande de réduction étant notée C2.

Dans l'exemple considéré, le dispositif 5 de commande de volume sonore comporte en outre:
- des moyens, 6, pour détecter une séquence de blocs consécutifs acceptables ou une séquence de blocs consécutifs acceptables et non acceptables dans laquelle prédominent des blocs acceptables,
- des moyens, 7, pour commander un rétablissement de volume sonore dans le cas de détection d'une telle séquence, cette commande de rétablissement étant notée C1.

Dans l'exemple considéré, les moyens 6 ou 8 de détection de séquence comportent en outre des moyens, non illustrés spécifiquement, pour donner un poids supérieur aux blocs non acceptables.

D'une manière générale on entend par rétablissement de volume sonore, soit le fait de remettre le volume sonore à sa valeur normale, s'il a été réduit précédemment, soit le fait de maintenir le volume à sa valeur normale, s'il n'a pas été réduit précédemment (la valeur normale étant par exemple la valeur sélectionnée par l'utilisateur dans le cas de volume sonore réglable par l'utilisateur).

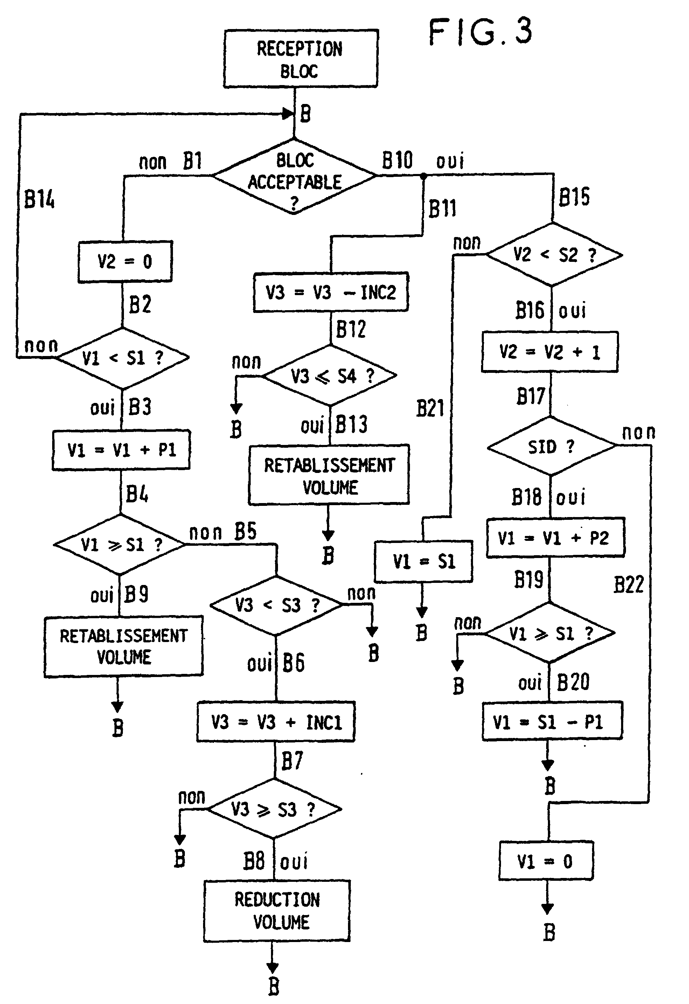

Le dispositif de commande illustré sur la figure 2 est par exemple réalisé au moyen d'un processeur de traitement de données opérant par exemple suivant l'algorithme illustré sur la figure 3.

Cet algorithme utilise les variables suivantes :
- V1 : variable servant à détecter une séquence de blocs consécutifs non acceptables et acceptables correspondant à une configuration utilisée en transmission discontinue,
- V2 : variable servant à comptabiliser des blocs consécutifs reçus estimés acceptables,
- V3 : variable servant à comptabiliser le nombre de blocs acceptables ou non acceptables prédominant dans une séquence de blocs consécutifs reçus.

Cet algorithme utilise également les paramètres suivants :
- Si : seuil auquel est comparé la variable V1 en vue de déterminer si l'on est en présence de transmission discontinue, et donc s'il y a lieu de rétablir le volume sonore,
- S2 : seuil auquel est comparé la variable V2,
- S3 : seuil auquel est comparé la variable V3 en vue de déterminer s'il y a lieu de réduire le volume sonore,
- S4 : seuil auquel est comparé la variable V3 en vue de déterminer s'il y a lieu de rétablir le volume sonore,
- INC1 : valeur dont on incrémente la variable V3 en cas de bloc reçu non acceptable,
- INC2 : valeur dont on incrémente la variable V3 en cas de bloc reçu acceptable, avec dans cet exemple INC2 < INC1, afin de donner un poids supérieur aux blocs non acceptables,
- P₁ : valeur dont on incrémente la variable V1 en cas de bloc reçu non acceptable,
- P₂ : valeur dont on incrémente la variable V1 en cas de bloc acceptable reçu à un emplacement réservé à la transmission de bruit dit de confort dans le cas de transmission discontinue, avec dans cet exemple P2 > P1.

A titre d'exemple non limitatif, correspondant plus particulièrement à une application au système GSM, on pourra prendre pour les divers paramètres définis plus haut les valeurs suivantes :
S1 = 20, S2 = 16, S3 = 16, S4 = 0,
INC1 = 2, INC2 = 1,
P1 = 1, P2 = 10

Suivant cet algorithme :
- si le bloc reçu est un bloc non acceptable :
   on réinitialise la variable V2, puis on détermine si la variable V1 est inférieure au seuil S1,

   . si la variable V1 est inférieure au seuil S1, on incrémente d'une valeur égale à P1 la variable V1 puis on détermine si la variable V1 est supérieure ou égale au seuil S1,

   .. si la variable V1 est supérieure ou égale au seuil S1, on en déduit que l'on est en présence de transmission discontinue, et on rétablit le volume sonore,

   ... si la variable- V1 est inférieure au seuil S1, on détermine si la variable V3 est inférieure au seuil S3,

   .... si la variable V3 est inférieure au seuil S3, on incrémente d'une valeur égale à INC1 la variable V3, puis on détermine si la variable V3 est supérieure ou égale au seuil S3,

   ..... si la variable V3 est supérieure ou égale au seuil S3, on réduit le volume sonore (jusqu'à éventuellement le couper s'il a déjà été réduit précédemment de cette façon),
- si le bloc reçu est un bloc acceptable :
   on détermine si la variable V2 est inférieure au seuil S2,

   . si la variable V2 n'est pas inférieure au seuil S2, on réinitialise la variable V1 à la valeur S1, sinon on incrémente la variable V2 puis on détermine si ce bloc acceptable reçu est à un emplacement réservé, dans le cas de transmission discontinue, à la transmission de bruit de confort, c'est-à-dire à l'emplacement d'une trame "SID" dans le système GSM par exemple,

   .. si ce bloc acceptable reçu n'est pas à un emplacement réservé, dans le cas de transmission discontinue, à la transmission de bruit de confort, on réinitialise la variable V1,

   ... si ce bloc acceptable reçu est à un emplacement réservé, dans le cas de transmission discontinue, à la transmission de bruit de confort, on incrémente d'une valeur égale à P2 la variable V1, puis on détermine si la variable V1 est supérieure ou égale au seuil S1,

   .... si la variable V1 est supérieure ou égale au seuil S1, on réinitialise la variable V1 à la valeur S1-P1,
- en outre, si le bloc reçu est un bloc acceptable :
   on décrémente d'une valeur égale à INC2 la variable V3 puis on détermine si la variable V3 est inférieure ou égale au seuil S4, et,
   si la variable V3 est inférieure ou égale au seuil S4, on rétablit le volume sonore.

Ainsi :
- dans le cas d'une séquence de blocs non acceptables reçus consécutivement on parcourt, pour chacun de ces blocs, successivement les branches B1 à B7 de l'algorithme, telles que repérées sur la figure 3, et, seulement dans le cas où ce nombre de blocs non acceptables consécutifs dépasse un seuil (en l'occurrence égal à S3), on poursuit par la branche B8 dans laquelle on procède à une réduction de volume,
- dans le cas d'une séquence de blocs acceptables reçus consécutivement on parcourt pour, chacun de ces blocs, successivement les branches B10, B11, B12, de cet alogrithme, et, seulement dans le cas où ce nombre de blocs acceptables consécutifs dépasse un seuil (en l'occurrence égal à S4) on poursuit par la branche B13 dans laquelle on procède à un rétablissement de volume,
- dans le cas d'une séquence de blocs reçus consécutifs comportant alternativement des blocs acceptables et des blocs non acceptables, on décrit alternativement les unes ou les autres des branches décrites ci-dessus, et, suivant le type (à savoir acceptable ou non acceptable), de bloc prédominant dans cette séquence, on pourra, si le nombre de blocs obtenu dépasse le seuil fixé, procéder soit à une baisse de volume, soit à un rétablissement de volume.

Par ailleurs, la détection de présence de transmission discontinue peut être obtenue en détectant une séquence de blocs consécutifs non acceptables et acceptables correspondant à une configuration utilisée en transmission discontinue, de la façon suivante :

En supposant par exemple que le premier bloc reçu dans le cadre de cette transmission discontinue est le bloc "vide" transmis dans la première trame de la structure de multitrame à considérer pour cette transmission :
- pour chacun des blocs "vides" reçus dans les premiers emplacements (ou trames), non réservés à la transmission de bruit de confort, d'une première multitrame, on parcourt les branches B1, B2, B3, B4 de cet algorithme,
- pour le bloc reçu dans l'emplacement suivant, réservé à la transmission de bruit de confort, de cette première multitrame (c'est-à-dire dans une trame "SID" dans le cas du système GSM par exemple), on décrit les branches B10 et B15 à B20 de cet algorithme,
- pour le bloc "vide" reçu dans le premier emplacement suivant, non réservé à la transmission de bruit de confort, de cette première multitrame, on décrit successivement les branches B1, B2, B3, B4, B9, de cet algorithme, d'où un rétablissement de volume sonore,
- pour les blocs "vides" reçus dans les emplacements suivants, non réservés à la transmission de bruit de confort, de cette première multitrame, on décrit pour chacun de ces blocs les branches B1, B2, B14 de cet algorithme, auquel cas on ne remodifie pas le volume,
- pour les blocs "vides" reçus dans les emplacements non réservés à la transmission de bruit de confort, de chacune des multitrames suivantes, on décrit, pour chacun de ces blocs, les branches B1, B2, B14 de cet algorithme, et pour le bloc reçu dans l'emplacement réservé à la transmission de bruit de confort, de chacune de ces multitrames suivantes, on décrit cet algorithme par les branches B15 à B20, auquel cas on ne remodifie pas non plus le volume.

Par ailleurs, dans cet exemple de réalisation, la détection de transmission discontinue peut en outre être obtenue en détectant la réception de blocs non acceptables à la suite de la réception d'une séquence de blocs acceptables en nombre suffisant. On considère en effet en pareil cas qu'il y a une forte présomption de présence de transmission discontinue, et donc on évite de réduire le volume sonore.

Pour cela, lorsque le nombre de blocs acceptables d'une telle séquence dépasse ainsi un seuil (en l'occurrence égal à S2), on décrit l'algorithme par les branches B10 et B15, puis par la branche B21 dans laquelle on force la variable V1 à la valeur S1.

Ainsi, pour chacun des blocs non acceptables reçus ensuite, on décrit l'algorithme par les branches B1, B2, B14, et donc le volume sonore ne risque pas d'être réduit comme cela aurait été le cas en parcourant les branches suivantes B1 à B8 de l'algorithme.

On notera que dans l'exemple de réalisation considéré, permettant un fonctionnement aussi bien en présence qu'en l'absence de transmission discontinue, il n'est pas possible de commander une réduction de volume sur réception d'un seul bloc non acceptable. On notera cependant que si l'on peut connaître à l'avance que l'on n'est pas en présence de transmission discontinue, ou si la technique de transmission discontinue n'est pas utilisée, on peut alors choisir de réduire le volume sur réception d'un seul bloc non acceptable.

Dans cet exemple, le volume sonore n'est par contre pas rétabli sur réception d'un seul bloc acceptable, mais sur réception d'une séquence de blocs consécutifs acceptables, ou d'une séquence de blocs consécutifs acceptables et non acceptables dans laquelle prédominent des blocs acceptables, ce qui entraîne encore une amélioration du confort d'écoute.

## Revendications

1. Dispositif de commande de volume sonore pour récepteur de signaux de parole codés par blocs, ce récepteur étant apte à recevoir des signaux transmis suivant une transmission dite discontinue et comportant des moyens (2) pour réaliser une estimation quant à la nature acceptable ou non acceptable des blocs reçus, ce dispositif (5) comportant des moyens pour commander une réduction de volume sonore dans le cas de réception de blocs non acceptables, et ce dispositif étant **caractérisé en ce qu'**il comporte :
- des moyens (10) dits de détection pour évaluer, grâce aux résultats de ladite estimation, une séquence de blocs consécutifs non acceptables et acceptables correspondant à une configuration utilisée en transmission discontinue, afin de déterminer si les signaux reçus sont des signaux transmis suivant ladite transmission discontinue,
- des moyens (11) pour commander un rétablissement de volume sonore dans le cas d'une détection de transmission discontinue des signaux.

2. Dispositif selon la revendication 1, **caractérisé en ce que** lesdits moyens de détection comportent:
- des moyens pour détecter la réception de blocs non acceptables à la suite de la réception d'une séquence de blocs acceptables en nombre suffisant.

3. Dispositif selon l'une des revendications 1 à 2, **caractérisé en ce qu'**il comporte en outre des moyens (8) pour détecter une séquence de blocs consécutifs non acceptables, ou une séquence de blocs consécutifs acceptables et non acceptables dans laquelle prédominent des blocs non acceptables, et **en ce que** lesdits moyens pour commander une réduction de volume sonore (9) sont activés dans le cas de détection d'une telle séquence.

4. Dispositif selon l'une des revendications 1 à 3, **caractérisé en ce qu'**il comporte en outre:
- des moyens (6) pour détecter une séquence de blocs consécutifs acceptables, ou une séquence de blocs consécutifs acceptables et non acceptables dans laquelle prédominent des blocs acceptables,
- des moyens (7) pour commander un rétablissement de volume sonore dans le cas de détection d'une telle séquence.

5. Dispositif selon l'une ou l'autre des revendications 3 et 4, **caractérisé en ce que** lesdits moyens (6, 8) de détection de séquence comportent des moyens pour donner un poids supérieur aux blocs non acceptables.

## Claims

1. A volume control device for a block coded speech signal receiver able to receive signals transmitted using the discontinuous transmission technique and including means (2) for estimating the acceptable or unacceptable nature of received blocks, the device (5) including means for commanding reduction of the volume if unacceptable blocks are received and being **characterized in that** it includes:
- detector means (10) for evaluating, by virtue of the results of the aforementioned estimation, a sequence of consecutive unacceptable and acceptable blocks corresponding to a configuration used in discontinuous transmission in order to determine if the signals received were transmitted using the discontinuous transmission technique, and
- means (11) for commanding restoration of the volume if discontinuous transmission of signals is detected.

2. A device according to claim 1 **characterized in that** said detector means include means for detecting the reception of unacceptable blocks following the reception of a sequence of a sufficient number of acceptable blocks.

3. A device according to either claim 1 or claim 2 **characterized in that** it further includes means (8) for detecting a sequence of consecutive unacceptable blocks or a sequence of consecutive acceptable and unacceptable blocks in which unacceptable blocks predominate and **in that** said means for commanding reduction of the volume (9) are activated if any such sequence is detected.

4. A device according to any of claims 1 to 3 **characterized in that** it further includes:
- means (6) for detecting a sequence of consecutive acceptable blocks or a sequence of consecutive acceptable and unacceptable blocks in which acceptable blocks predominate, and
- means (7) for commanding restoration of the volume if any such sequence is detected.

5. A device according to either claim 3 or claim 4 **characterized in that** said sequence detector means (6, 8) include means for assigning a greater weight to unacceptable blocks.

## Patentansprüche

1. Lautstärke-Steuervorrichtung für Empfänger von in Blöcken codierten Sprachsignalen, wobei dieser Empfänger Signale empfangen kann, die in einer so genannten diskontinuierlichen Übertragung übertragen werden, und Mittel (2) umfasst, die eine Schätzung hinsichtlich der Tatsache vornehmen, ob die empfangenen Blöcke annehmbar oder nicht annehmbar sind, wobei die Vorrichtung (5) Mittel umfasst, die eine Verringerung der Lautstärke in dem Fall befehlen, in dem nicht annehmbare Blöcke empfangen werden, und wobei die Vorrichtung **dadurch gekennzeichnet ist, dass** sie umfasst:
- so genannte Erfassungsmittel (10), die anhand der Ergebnisse dieser Schätzung eine Folge aus aufeinander folgenden nicht annehmbaren und annehmbaren Blöcken, die einer bei der diskontinuierlichen Übertragung verwendeten Konfiguration entsprechen, bewerten, um zu bestimmen, ob die empfangenen Signale solche Signale sind, die gemäß der diskontinuierlichen Übertragung übertragen werden, und
- Mittel (11), die eine Wiederherstellung der Lautstärke in dem Fall befehlen, in dem eine diskontinuierliche Übertragung von Signalen erfasst wird.

2. Vorrichtung nach Anspruch 1, **dadurch gekennzeichnet, dass** die Erfassungsmittel umfassen:
- Mittel, die den Empfang von nicht annehmbaren Blöcken nach dem Empfang einer Folge annehmbarer Blöcke in ausreichender Anzahl erfassen.

3. Vorrichtung nach einem der Ansprüche 1 bis 2, **dadurch gekennzeichnet, dass** sie außerdem Mittel (8) umfasst, die eine Folge von aufeinander folgenden nicht annehmbaren Blöcken oder eine Folge von aufeinander folgenden annehmbaren und nicht annehmbaren Blöcken, in der nicht annehmbare Blöcke vorherrschen, erlassen, und dass die Mittel, die eine Verringerung der Lautstärke (9) befehlen, im Fall einer Erfassung einer solchen Folge aktiviert werden.

4. Vorrichtung nach einem der Ansprüche 1 bis 3, **dadurch gekennzeichnet, dass** sie außerdem umfasst:
- Mittel (6), die eine Folge von aufeinander folgenden annehmbaren Blöcken oder eine Folge von aufeinander folgenden annehmbaren und nicht annehmbaren Blöcken, in der die annehmbaren Blöcke vorherrschen, erfassen, und
- Mittel (7), die eine Wiederherstellung der Lautstärke im Fall der Erfassung einer solchen Folge befehlen.

5. Vorrichtung nach einem der Ansprüche 3 und 4, **dadurch gekennzeichnet, dass** die Mittel (6, 8) für die Erfassung einer Folge Mittel umfassen, die den nicht annehmbaren Blöcken ein höheres Gewicht verleihen.
